Europäisches Patentamt

European Patent Office

Office européen des brevets

(11) Publication number: **0 206 541 B1**

## EUROPEAN PATENT SPECIFICATION

(45) Date of publication of patent specification: **22.01.92**  (51) Int. Cl.⁵: **C30B 15/00**, C30B 29/42

(21) Application number: **86304008.5**

(22) Date of filing: **27.05.86**

(54) Gallium arsenide single crystals, and process for the preparation thereof.

(30) Priority: **29.05.85 IT 2093685**

(43) Date of publication of application:
**30.12.86 Bulletin 86/52**

(45) Publication of the grant of the patent:
**22.01.92 Bulletin 92/04**

(84) Designated Contracting States:
**BE CH DE FR GB LI NL**

(56) References cited:
**GB-A- 2 108 404**
**US-A- 4 483 735**

**JOURNAL OF CRYSTAL GROWTH, vol. 70, no. 1/2, December 1984, pages 169-178, Elsevier Science Publishers, Amsterdam, NL; A.G. ELLIOT et al.: "Low dislocation density, large diameter, liquid encapsulated czochralski growth of GaAs"**

(73) Proprietor: **Montedison S.p.A.**
**Patents & Licensing Dept. Foro Buonaparte, 31 P.O. Box 10528**
**I-20121 Milan(IT)**

Proprietor: **CONSIGLIO NAZIONALE DELLE RICERCHE**

**Piazzale Aldo Moro, 7**
**I-00198 Roma(IT)**

(72) Inventor: **Mattera, Adriano**
**13, via Tadini**
**I-28100 Novara(IT)**
Inventor: **Fornari, Roberto**
**9, via Bachelet**
**I-43100 Parma(IT)**
Inventor: **Magnanini, Renota**
**64, Via Iatti 64**
**I-42045 Luzzara Reggio Emilia(IT)**
Inventor: **Paorici, Carlo**
**36, via Zarotto**
**I-43100 Parma(IT)**
Inventor: **Zanotti, Lucio**
**8, via Silvio Pellico**
**I-43100 Parma(IT)**
Inventor: **Zuccalli, Giovanni**
**3, via Paullo**
**I-43100 Parma(IT)**

(74) Representative: **Whalley, Kevin et al**
**MARKS & CLERK 57/60 Lincoln's Inn Fields**
**London WC2A 3LS(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

# EP 0 206 541 B1

## Description

The present invention relates to gallium arsenide (GaAs) single crystals having high structural characteristics and of high purity, and to a process for the preparation thereof.

More particularly, the invention relates to GaAs single crystals with low dislocation density and low impurity content through contamination, diameter of at least 2.5 cm (1 inch) with minimum variations in diameter of ± 2 mm, and 0.2 to 1 kg weight.

It is known that GaAs is a semiconductor used as substrate in devices which find application in:

- traditional telecommunication systems (radio and telephone links (bridges), T.V. etc.),
- communication systems on optical fibers (discrete and integrated components),
- distribution systems for television programs via satellite,
- radar systems for various uses, for instance civil,
- systems for switching high-speed numeric signals.

Among the most widespread GaAs devices, there are those discrete devices such as optoelectronic devices (photodetectors, senders, laser, LED (light emitting diodes), and microwave devices (Gunn diodes, IMPATT diodes, Schottky diodes, etc.).

Moreover, GaAs is used in integrated circuits: analogic, digital, and monolithic IC (integrated circuit) of medium or large scale integration.

It is known from technical and patent literature that the most used processes for the growth of GaAs single crystals on an industrial scale are substantially two:

- Czochralski liquid encapsulation technique (LEC), and
- Bridgman horizontal oven technique (HBG).

This latter technique has the advantage of giving low dislocation density crystals, but has the drawback of imparting high silicon contamination, derived from the quartz tube used in the growth. Such contamination is intrinsic to this technology. Moreover, this technique is not very flexible, because it only allows ⟨111⟩ oriented crystals to be obtained with good characteristics and cylindrical shape but not with a circular section. This is a notable drawback because most of the electronic devices use ⟨100⟩ oriented single crystals with cylindrical shape and circular section. Moreover the presence of high concentration of silicon does not allow the fabrication of devices which use semi-insulating GaAs, such as microwave devices.

The Bridgman technique renders the scale passage to single crystals with high diameter and weight problematic due to intrinsic difficulties of the technique itself.

Generally, in order to produce crystals of large diameter, usually at least 2.5 cm (1 inch), and varying weight, also exceeding 1 kg, the LEC process is used. This method allows crystals to be obtained having the desired weight and dimensions (diameter) and circular section cylindrical shape, which obviously require growth times varying according to the weight. In this way, the presence of impurities is avoided and relatively reduced cycle times are used. However, the LEC technique, notwithstanding the various weight and diameter control methods usually used, has the drawback of giving high dislocation density crystals, about $10^4$ - $10^5$ cm$^{-2}$, and a notable lack of structural and/or composition homogeneity, both axial and radial, when the crystals have a diameter of at least 2.5 cm (1 inch).

Moreover, in the LEC technique, polycrystals obtained with the Bridgman process are often used for the growth, giving single crystals with a high silicon impurity concentration. To improve the purity of the single crystal, the same CZ (Czochralski) oven for the synthesis in situ of the polycrystal is used, starting from the elements gallium (Ga) and arsenic (As), and for the following successive growth of the single crystal.

However, even single crystals which are grown with this expedient have a dislocation concentration which is too high, a lack of structural homogeneity due to the presence of microdefects, microprecipitates, etc., and moreover frequently have a lack of uniformity in diameter, generally ± 3-5 mm for diameters of at least 2.5 cm (1 inch). Moreover, these characteristics tend to become worse with increase of weight. This lack of diameter homogeneity causes considerable loss of utilizable material in processing, in that constant diameter slices (wafers) are required. Moreover, this lack of diameter homogeneity has an influence on the formation of reticular defects, in particular of dislocations.

The high number of dislocations and the lack of structural homogeneity have adverse effects in the processing of the slices because of diffusive phenomena, and consequently have an adverse influence on the characteristics of the devices, which are reproducibility, average life, noise, etc.

For instance, in the epitaxial growth processes, the use of slices containing a high number of defects provokes migration of the defects and of the impurities from the substrate to the epitaxial layer, above all in the vicinity of the junction.

To diminish the dislocation density, the crystals are generally doped with dopants, such as boron, silicon, selenium, sulphur and tellurium, in quantities of $10^{16}$ - $5.10^{17}$ atoms/cm$^3$. In particular, it is observed

2

that with some of these dopants the dislocations tend to disappear when using a higher concentration of dopant generally of $5.10^{17}$ - $10^{19}$ atoms/cm$^3$.

Methods normally used to diminish the dislocations with dopants are described in GB-A-2,108,404.

These systems for reducing the dislocations with the use of dopants are not suitable for preparing single crystals to be used as intrinsic semi-insulators, in that the presence of the dopants renders the single crystals semiconductors.

The resistivity $\rho$ in fact lowers from values of about $10^7\,\Omega$cm to values less than $10\,\Omega$cm.

The presence, for instance, of $10^{16}$ - $10^{19}$ atoms/cm$^3$ of dopant, renders the single crystals unsuitable for applications as intrinsic semi-insulators. Only for certain applications, such as for solar cells, dopant quantities of $10^{17}$ - $5.10^{18}$ atoms/cm$^3$ are required.

Therefore, it is desirable to obtain GaAs single crystals with such a low dislocation density as to make them suitable for applications as intrinsic semi-insulators, for instance for integrated logic, FET or GUNN diodes. Moreover, a low number of dislocations makes the single crystals preferable in that it allows for high quality devices with good signal reproducibility, low noise, and high average life.

However, it is also desirable to provide single crystals having a low number of dislocations for certain applications wherein doped single crystals are required. In fact, if the number of dislocations is high, it is necessary to use a high quantity of dopant, from $5.10^{17}$ to $10^{19}$ atoms cm$^{-3}$, to reduce it.

This presents drawbacks in that microprecipitates can be generated which give devices with electrical characteristics of poor quality, for instance the cutoff frequency in the Gunn diodes is lowered, as the average life of laser, and the signal propagation velocities in electronic systems are lowered, for example in telecommunications, in computers, and in radar systems.

GaAs single crystals, obtained with the LEC technique, having heavy weight, circular section cylindrical shape, low impurity content, any orientation, constant diameters so as to have a low wastage in processing, and a low number of dislocations without using dopants, would considerably reduce all the described drawbacks, and would render GaAs as a material more widely utilizable in the various above mentioned applications.

It has now been unexpectedly found that GaAs single crystals with low dislocation content can be grown, both for non-doped crystals and for crystals with low dopant content, which, besides having a low impurity content, are at least 2.5 cm (1 inch) in diameter and have a weight up to 1 kg, and which have the aggregate of the characteristics hereinbefore described.

Accordingly, the present invention provides GaAs single crystals having a diameter from 2.5 to 5.1 cm (1 to 2 inches), a weight from 200 g to 1 kg, an impurity content less than or equal to $5.10^{15}$ atoms/cm$^3$, an EPD (etch pit density) dislocation density of from $5.10^2$ to $8.10^3$ cm$^{-2}$, without the use of dopant, a diameter constancy of ± 2 mm, and having a circular section cylindrical shape, and any predetermined orientation.

Preferably, the GaAs single crystals have a diameter from 2.5 to 5.1 cm (1 to 2 inches), and an orientation according to the directions ⟨111⟩, ⟨100⟩ or ⟨110⟩. The most preferred orientations are according to the directions ⟨111⟩ and ⟨100⟩. The EPD (etch pit density) dislocations in the case of single crystals with ⟨111⟩ orientation are from $5.10^2$ to $10^3$ cm$^{-2}$ both axially and radially; in the case of ⟨100⟩ orientation, the EPD dislocations are from $10^3$ to $8.10^3$ cm$^{-2}$.

The GaAs single crystals of the invention can be doped with $10^{17}$ - $10^{18}$ atoms/cm$^3$ of dopant, to obtain semiconductors for the various above mentioned practical applications, without microprecipitates. In this case, the number of dislocations may be as low as less than $10^2$ cm$^{-2}$ and can even completely disappear.

As dopants, those commonly used in the art are used. For example, silicon, sulphur, tellurium, selenium, boron, chromium and zinc can be used.

The absence of microprecipitates was observed under an electronic microscope with the TEM (transmission electron microscopy) technique.

Moreover, it was found that the oriented undoped single crystals ⟨111⟩ have semi-insulating characteristics with resistivity $\rho$ of from $10^6$ to $10^7\,\Omega$cm, and with mobility $\mu$ from 2000 to 3500 cm$^2$/(volt.sec) for undoped n-type GaAs. Instead, in the case of undoped p-type GaAs, it was found that the mobility lowers remarkably.

The GaAs single crystals of the present invention may be obtained by a process which uses the modified LEC technique in one cycle starting from the elements Ga and As with synthesis of the polycrystal in situ and subsequent growth of the single crystal, as described hereinafter. It is possible to obtain the $\overline{GaAs}$ single crystals of the invention by use of suitable elementary steps in the synthesis and growth phases, as described hereinafter, and by the use of a very precise automation system for controlling and programming the temperature in the growth chamber, obtained by means of an interface between a voltage ramp programmer and a temperature regulator.

The interface and its functions on the output voltages of a commercial programmer are described in detail in EP-A-0 204 508. Preferably, also there are used in the present invention the programmer, the CZ oven and the regulator described in EP-A-0 204 508.

In particular, the growth equipment used is suitably a radio frequency or resistance ADL mod. HPCZ oven for crystals up to 3 kg. There may be suitably used Heralux (TM) quartz crucibles having a diameter of 5 - 10 cm and height of 6 - 12 cm, high-purity Ringsdorff graphite susceptors (impurity less than 150 ppm), As (purity 6N) produced by MCP, Ga (purity 7N) manufactured by Alusuisse, and $B_2O_3$ Puratronic produced by JMC. The boric oxide underwent a vacuum (1.3 x $10^{-2}$ Pa ($10^{-4}$ Torr)) purification cycle in an oven at 1000° C for 3-4 hours and had residual impurities of less than 1 ppm.

High purity $N_2$ is suitably used (special UPP having an $O_2$ content of less than 1 ppm), as inert gas in the various phases of the cycle, even though it is possible to use other superpure inert gases such as Argon.

High purity BN crucibles can also be used so as to avoid any contamination of the GaAs single or polycrystals by silicon and by oxygen deriving from the quartz crucibles.

The process for the preparation of the GaAs single crystals of the invention comprises the following steps:

a) preparation of a GaAs polycrystal in situ by reacting the elements Ga and As, under conditions of inert gas high pressure of at least 5 MPa (50 atm), preferably from 5 to 7 MPa (50 to 70 atm), operating in the presence of a quantity of $B_2O_3$ sufficient to produce a molten layer 0.7 to 2 cm thick, using a commercial programmer of voltage ramps on an output voltage channel having minimum voltage increases of about 10 mV, said voltage being increased during this step in such a way as to limit the evaporation of the As to values less than 1% by weight with respect of the initial quantity of As used, during the entire step so that the polycrystal stoichiometry is comprised between the following values:

$$0.49 < \frac{As}{Ga + As} < 0.51$$

b) growth of a single crystal using the polycrystal obtained in step (a) which comprises melting the polycrystal at a temperature from 1250° C to 1300° C. under an inert gas pressure of 6 to 7 MPa (60-70 atm) in the growth chamber; lowering the temperature until the contact between seed and molten material is formed; and a growth phase at a low inert gas pressure of from 0.2 to 0.6 MPa (2 to 6 atm) or at a high pressure of from 2.5 to 5 MPa (25 to 50 atm), for the formation of a neck with a diameter of 2-3 mm and a length of 5-14 mm, formation of a shoulder in a time of 1-2 hours, and formation of the circular section cylindrical shape single crystal of constant diameter suitably in a time of 3-5 hours; the said step (b) being carried out with a very strict control of the temperature obtained automatically by means of a microprocessor, inserted between the oven and the programmer, which permits output voltages to be obtained from channel 2 of said programmer with increases of not more than 1 mV; and

c) cooling the single crystal, comprising a slow and controlled decreasing stage at 30° - 60° C/hour until a temperature of 900°-1000° C is reached, and a faster cooling stage at 80° - 120° C/hour until room temperature is reached.

For illustrative purposes, the synthesis steps of the polycrystal and those of the subsequent growth of the single crystal, are described separately and in more detail hereinbelow.

Synthesis of the polycrystal.

The synthesis of the polycrystal is carried out with the same equipment used for the growth, starting from the elements. The method used comprises a series of suitably determined elementary steps which include the automatic control of the voltage variations, of the order of 10 mV, using a normal commercial voltage ramp programmer, For instance, a Honeywell programmer DCP 770 can be used for this purpose.

In this way, it is possible to eliminate all the manual operations for voltage variation which give rise to uncontrolled variations of the temperature in the growth chamber, with consequent poor reproducibility of results.

The automatic voltage ramp programmer is connected to an oven temperature regulator by means of a microprocessor as described in EP-A-0 204 508.

Any Czochralski CZ oven can be used as a growth oven, in particular the one hereinbefore described. In this case, the temperature regulator is a CAT Series 80.

The automatic variations of voltage cause controlled variations of temperature in the oven with a

4

sensitivity of $1°C$. In this way, it is possible to grow GaAs polycrystals with a defined stoichiometry comprised in the range:

$$(1) \qquad 0.49 < \frac{As}{Ga + As} < 0.51;$$

In fact, it is known that polycrystals having even a minimum deviation from the stoichiometry of the range of equation (1) give rise to single crystals wherein the concentration and the nature of the reticular defects, such as vacancies, antisites, precipitates and inclusions, are not controllable. In this way, using this polycrystal as a precursor, it is impossible to obtain single crystals having reproducible electrical characteristics, such as trap concentrations, mobility, type of conductivity and thermal stability, and reproducible structural characteristics, such as dislocation density.

In order to obtain polycrystals having a stoichiometry comprised within the range of equation (1), the temperature variations are an essential parameter, even if it is necessary to take into consideration the other parameters hereinbelow mentioned.

First arsenic and then gallium are loaded, in approximately stoichiometric ratio (molar ratio about 1:1) in the crucible, and then $B_2O_3$ is loaded, in such a way that when molten it forms a layer from 0.7 to 2 cm thick.

Then, after having passed an inert gas at a pressure of around $10^5$ Pa (a few atmospheres pressure), for instance very pure nitrogen or argon, into the growth chamber, the crucible is heated so as to melt the $B_2O_3$, and the $B_2O_3$ is kept at its melting point or higher, while arsenic is kept at a temperature at which it is still in the solid state, about $100°C$ to $300°C$.

Then the pressure of the inert gas is further increased to 5 to 7 MPa (50 to 70 atm), or higher, and the temperature of the gallium and arsenic is simultaneously gradually increased up to the reaction temperature between Ga and As so as to give GaAs polycrystals. Such reaction starts at $820°C$ and this or an even higher temperature of for instance from $820°C$ to $880°C$ is maintained for the necessary time, which depends on the absolute weight quantity of Ga and As under reaction.

For instance, to prepare a 100 g polycrystal, the reaction is carried out for 1 to 2 hours.

Generally, it can be useful to remelt the obtained polycrystal and re-crystallize it to avoid lack of structural homogeneity.

Operating as described above, polycrystals having a stoichiometry which is included within the range of equation (1) can be obtained.

The thus obtained polycrystal has an impurity level of not more than $5.10^{15}$ atoms/cm$^3$, and the reaction yield is very high, being even capable of reaching the theoretical value.

A person skilled in the art can easily determine, on the basis of the indicated parameter values, the utilizable conditions even for CZ ovens of different type.

The thus obtained polycrystal can be cooled with the cooling cycle indicated hereinafter for the single crystal, to determine its stoichiometry, impurities, and electrical and structural characteristics.

However, generally it is preferable to determine such characteristics indirectly, namely by measuring said characteristics on the single crystal grown using the thus prepared polycrystal as a precursor, and proceeding directly in a single cycle with the system as such for the formation of the single crystal.

Growth of the single crystal.

The single crystal is grown by using the polycrystal, prepared as hereinbefore described, as precursor, without cooling, the polycrystal having a high purity and a high structural and stoichiometric homogeneity, included in the range of equation (1), and there are applied a series of suitable elementary steps, as indicated hereinbelow, and automized with a voltage ramp programmer (Honeywell DCP 7700) interfaced with a suitable electronic device to a temperature regulator (CAT series 80) which permits the voltage to be changed by values of not more than 1mV with temperature variations of $0.1°C$ or below.

The evaporation of the arsenic, the generation of reticular defects, the capturing of impurities in the growth and cooling step of the crystal are thus minimized, and the diameter is kept constant (±2mm).

The interface microprocessor and its manner of operation are described in the synthesis of the polycrystal hereinbefore.

The steps carried out in the growth of the single crystal following the synthesis of the polycrystal, namely continuing with the operations from the point at which the system was after obtaining the

5

polycrystal, are essentially the following:

- melting the polycrystal at a temperature higher than that of melting, generally from 1250˚C to 1300˚C and under an inert gas pressure in the growth chamber of 6 to 7 MPa (60 to 70 atm;)
- lowering the melt temperature to that of growth, which is experimentally determined by dipping a single crystal seed in the melt and noting whether the contact between the seed and the melt is maintained; if this does not happen then the temperature is slightly lowered. The contact can be determined by the electrical instruments with which the CZ is equipped, for instance observing whether there is a flow of current in an amperometer when the seed closes an electric circuit with the melt. Generally, the growth temperature is from 1230˚C to 1245˚C;
- at this stage, growth can occur at low inert gas pressure, generally from 0.2 to 0.6 MPa (2 to 6 atm), or at high pressure, for example from 2.5 to 5 MPa (25 to 50 atm). However, it is preferable to work at low pressure;
- at this stage of the cycle, the growth phase, strictly speaking, starts at the previously determined growth temperature, and the system is stabilized at this temperature;
- the seed "neck" formation phase starts, which neck is about 2-3 mm in diameter and 5-14 mm long, to minimize the propagation of the dislocations from the seed to the single crystal;
- then the formation of the "shoulder" of the crystal starts, in fairly long times so as to form a sufficiently flat shoulder, namely with the smallest possible angle between the seed and the face of the shoulder. Generally, this time varies from 1 to 2 hours;
- the formation of the circular section cylindrical shape single crystal with constant diameter starts. The time depends on the charge of polycrystal used. Generally, the time varies from 3 to 5 hours for polycrystals from 300 to 500 g.

In this stage, the use of the microprocessor, as hereinbefore described, is essential for controlling and varying the melt temperature, so that this temperature is varied in the most controlled manner possible in order to avoid the creation of reticular defects. Variations of 1 mV, or less, corresponding to temperature variations of melt of about 0.1˚C, or less, have been shown to be the most suitable for obtaining GaAs single crystals with the dislocation values of the invention. These small variations of voltage increment in this stage permit control of the fluid mechanics of the melt, namely the geometric evolution of the melt - crystal interface, in such a way as to minimize defect formation.

The pulling speeds used in the growth phase vary from 0.5 to 2 cm/hour, the shaft anti-clockwise rotation speed being from 1.5 to 6 rpm, and the crucible clockwise rotation speed being from 2 to 5 rpm.

With all these parameters, it is possible for a skilled person to control and determine the best growth conditions of the single crystal.

Cooling.

When the single crystal preparation cycle is terminated, the cooling phase inside the chamber is carried out in a slow and controlled manner, generally decreasing the temperature by 30˚ - 60˚C/hour until a temperature of 900˚ - 1000˚C inside the chamber itself is reached.

Then cooling is carried out at a faster rate, about 80˚ - 120˚C/hour, until room temperature is reached.

The seed which is used has a predetermined orientation and is obtained from a previously prepared single crystal, according to known methods.

At the end of the single crystal growth, the single crystal stoichiometry can be checked by means of the following equation (2):

(2) Ga weight + As weight + seed weight = single crystal weight + GaAs residual polycrystal weight + evaporated As weight.

All the weights indicated in equation (2) being known, except the weight of the evaporated arsenic, this value can be determined from equation (2).

For all the growths of the invention, the loss due to As evaporation is not more than 1% by weight of the loaded arsenic.

Such losses give rise to single crystals having a stoichiometry included in the range of equation (1). Consequently, even a solid or molten polycrystal satisfies the equation (1).

In the following description, reference will be made to the accompanying drawings, in which:

Figure 1 indicates, in part (a) the temperature gradient before the fusion of $B_2O_3$, and in part (b) the temperature gradient during the fusion of the GaAs polycrystal, as referred to in Example 1 below;

Figure 2 is a graph of voltage versus time in respect of the process of the invention using an automated system consisting of a microprocessor and a programmer.

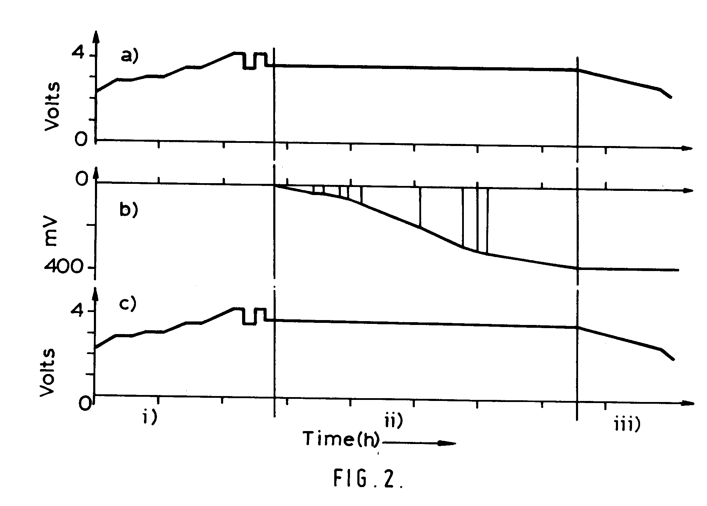

In Figure 2, the various voltages which can be used during the entire process using the automated system consisting of the microprocessor and the programmer, are shown. The minimum and maximum voltage values and the relevant increments of the various channels are given in Example 1.

i) Synthesis of the GaAs. High voltage increments are required, therefore adjustment occurs in steps exceeding 10 mV. Programming is carried out with channel CH3 in the range 1-5 volts, whilst channel CH2 is kept constant, at zero value, Figure 2, (a).

(ii)Growth of the crystal. Having supplied the oven with the power necessary to melt the entire GaAs charge, the output voltage of channel CH3 is kept constant. The voltage decrements (less than or equal to 1 mV) necessary for obtaining the crystal in a regular, cylindrical shape, are programmed by channel CH2 which subtracts voltage from the total value obtained in the synthesis and melting. Figure 2,(b).

(iii)Cooling. Upon completion of growth, the voltage is to be gradually reduced so as to permit a correct cooling of the crystal. Keeping the voltage value of channel CH2 constant, the cooling in various stages is programmed on channel CH3, which again begins to work, after inactivity during the entire growth time, Figure 2, (c).

The invention will be further described with reference to the following illustrative Examples.

Example 1

Synthesis of the GaAs polycrystal.

182 g. of Ga (purity 7N) Alusuisse, 202.2 g. of As (purity 6N) MCP with molar ratio Ga/As of 0.968. 70 g. of JMC $B_2O_3$ Puratronic purified by the method hereinabove described and corresponding, in the molten state, to a thickness of 11 mm, were loaded in a Heralux (TM) quartz crucible (diameter = 20 mm, height = 70 cm). A CZ (Czochralski) oven was started up with a suitable voltage ramp programmer interfaced through a microprocessor with a CAT series 8 temperature regulator.

The CZ oven was of the type hereinbefore mentioned; the microprocessor used was as described in EP-A-0 204 508.

The programmer had two channels CH2 and CH3 with output voltages $V_2$ and $V_3$ which varied from 1 to 5 volts and with minimum increments of 10 mV.

The microprocessor referred to in EP-A-0 204 508 has an output voltage $V_{out}$ in mV defined by the equation:

$$V_{out} = V_3 + \frac{V_2}{10} - 500$$

wherein 500 is a supplied voltage V, in mV, and the minimum increments of $V_{out}$ are 1 mV.

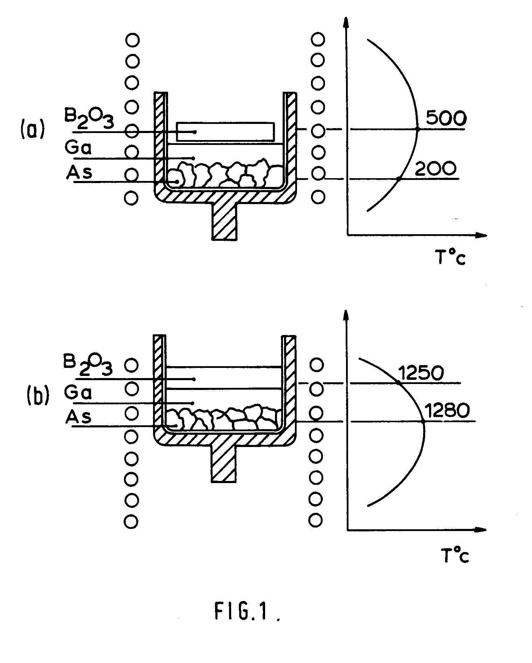

In Table 1, elementary stages (stage) up to stage 8, temperature, the positions of the growth station (including the crucible) in the various positions inside the radio-frequency coil with the relevant temperature gradients in the initial and final conditions of the synthesis (see Figure 1), the $N_2$ pressure, the times for every stage, relative to the synthesis of the polycrystal, are shown.

In Table 2A, the programme of the Honeywell voltage ramp programmer hereinbefore mentioned for the synthesis of the polycrystal with the indication of the channel used, the stage corresponding to the various used voltages in mV, the permanence duration at a fixed value of the set point (stoppage), and the time spent passing from one set point to another (ramp) which determines the voltage variation in the time unit, are shown.

In the column "Notes" of Tables 1 and 2A, it is possible to correlate the variations of temperature inside the growth chamber with the variations of voltage applied in the time unit.

At the end of the synthesis, the polycrystal can be cooled according to the cooling cycle described for the single crystal hereinafter, stages 14-15 of Table 2A and 21-22 of Table 2B.

Generally, the qualities of the polycrystal can be checked on the basis of the characteristics of the single crystal grown by using the thus prepared polycrystal as precursor.

Synthesis of the GaAs single crystal

The hereinbefore obtained polycrystal is melted and used for the growth of the single crystal, using the stages shown in the Tables 1, 2A, and in detail in the Table 2B.

Practically, the operations of the present invention as generally described hereinbefore, are carried out with the values of the various variables shown in the Tables.

The pulling conditions were the following:

Pulling speed: 1.5 cm/hour;

Shaft rotation speed: 6 rpm anticlockwise;

Crucible rotation speed: 4 rpm clockwise.

A seed having the orientation ⟨111⟩ was used,

with nitrogen pressure of 0.3 MPa (3 atm) in the growth chamber.

The undoped single crystal obtained is semi-insulating n-type and weighs 380 g.

The characteristics of the single crystal are the following:

(EPD) dislocations about $10^3$ cm$^{-2}$ both axially and radially;

$\rho$ = $10^6$ - $10^7 \Omega$ cm;

$\mu$ = 2000 - 3500 cm$^2$/(volt.sec);

Impurities = less than $5.10^{15}$ atoms/cm$^3$;

Diameter = 40 ± 2 mm.

Example 2.

Polycrystal synthesis and subsequent growth of a 1 kg single crystal.

500 g of Ga (purity 7N) Alusuisse, 548 g of As (purity 6N) MCP with Ga/As molar ratio of 0.98 were loaded with $B_2O_3$ (100 g) Puratronic JMC purified as hereinbefore described, in a Heralux (TM) quartz crucible (diameter = 80 mm and height = 80 mm). A ⟨111⟩ seed was used. The synthesis process of the polycrystal was the same as in Example 1 and the program for the growth of the single crystal was that shown in Table 2C. 0.3 MPa (3 atm) of ultrapure $N_2$ pressure was used. Growth operating conditions were the same as in Example 1. An undoped n-type ⟨111⟩ single crystal with characteristics similar to those of the single crystal obtained in Example 1, 4.5 cm ± 2 mm in diameter and 1 kg in weight, was obtained.

Example 3.

Synthesis of a polycrystal and subsequent growth of a single crystal 2.8 cm in diameter.

150 g of Ga (purity 7N) Alusuisse, 164 g of As (purity 6N) with molar ratio Ga/As of 0.98, and $B_2O_3$ (70 g) Puratronic JMC purified as hereinbefore described were loaded. A ⟨111⟩ seed was used. The synthesis and the growth were carried out as in Example 1 with the use of the growth program shown in Table 2D to obtain a perfect n-type ⟨111⟩ crystal 2.8 cm ± 2 mm in diameter having a weight of 300 g.

The characteristics of the crystal were similar to those of the crystal of Example 1: EPD was $10^2$ - $10^3$ cm$^{-2}$.

Example 4.

Silicon doped ⟨111⟩ single crystal.

Example 1 was repeated, except that 0.2 mg of silicon for every gram of GaAs polycrystal was used as dopant. Practically the silicon was also added while loading the Ga and As. A ⟨111⟩ seed was used, and the synthesis and growth were as described in Example 1. An n-type ⟨111⟩ doped crystal 380 g in weight with the following characteristics was obtained:

(EPD) = 0 - $10^2$ cm$^{-2}$;

$\rho$ = $10^{-3}$ $\Omega$cm;

$\mu$ = 1200 cm$^2$/(volt.sec);

N = $5.10^{18}$ atoms/cm$^3$, where

N is the number of carriers

Example 5.

Undoped ⟨100⟩ single crystal.

Ga, As and $B_2O_3$ were loaded as in Example 3, and the working conditions were as described in Example 1. A ⟨100⟩ seed was used and the synthesis and growth were the same as in Example 1 using the

8

program of Example 1. An n-type $\langle 100 \rangle$ undoped crystal, weighing 300 g, with the following characteristics was obtained:

EPD $= 10^3 - 5.10^3$ cm$^{-2}$;

$\rho = 10^4 - 10^5$ $\Omega$ cm;

$\mu = 1000 - 1500$ cm$^2$/vol.sec;

diameter $= 4.5$ cm $\pm$ 2 mm;

impurities $=$ less than $5.10^{15}$ atoms/cm$^3$.

Example 6.

Growth of an n-type $\langle 111 \rangle$ single crystal at 3 MPa (30 atm) of N$_2$ pressure.

Ga, As and B$_2$O$_3$ were loaded in the same quantities and in the same manner as in Example 1, and a $\langle 111 \rangle$ seed was used operating at 3 MPa (30 atm) during the growth instead of at 0.3 MPa (3 atm) with ultrapure N$_2$. The synthesis and growth operations were as described in Example 1, but using the growth program shown in Table 2E. An n-type undoped $\langle 111 \rangle$ crystal, 380 g in weight and 5 cm $\pm$ 2 mm in diameter with electrical and structural characteristics similar to those of the crystal of Example 1, was obtained.

Example 7 (comparison).

Example 6 was repeated, but using 300 g of a commercial polycrystal produced by M.C.P. Electronics Limited; 70 g of B$_2$O$_3$ and a $\langle 111 \rangle$ orientated seed were used. The program shown in Table 2E was used in the growth phase.

A single crystal 45 $\pm$ 2 mm in diameter, 295 g in weight, with the following characteristics, was obtained:

EPD $= 1-5.10^4$ cm$^{-2}$;

$\rho = 2.2 \Omega$ cm;

$\mu = 3430$ cm$^2$/(volt.sec).

From a comparison of the obtained results with those of Example 6, it is observed that the dislocations are higher by a factor of 10, and the resistivity is lower, since the polycrystal was obtained by the Bridgman method and therefore doped with silicon, and therefore a semi-insulating single crystal, as in the present invention (Example 6), was not obtained.

TABLE 1 — STAGES FOR THE SYNTHESIS AND THE GROWTH OF GaAs IN CZ OVEN

| Stage | Temperature (1) °C | Gradient (2) | N₂ Pressure/ MPa (atm) | Time (min ) | NOTES |
|---|---|---|---|---|---|
| 0 | 20 | 1 | $1.3 \times 10^{-9} (10^{-5}$ (Torr)) | 600 | Vacuum treatment of the charge |
| 1 | 20–600 | 1 | 0.5 $(5)$ | 20 | $B_2O_3$ Melting |
| 2 | 600 | 1 | 6 $(60)$ | 15 | Charge covering with $B_2O_3$ |
| 3 | 600 | 2 | 6 $(60)$ | 5 | Change of temperature gradient |
| 4 | 600–820 | 2 | 6 $(60)$ | 15 | |
| 5 | 820 | 2 | 6 $(60)$ | 15 | Reaction |
| 6 | 820–1250 | 2 | 6 $(60)$ | 20 | |
| 7 | 1250 | 2 | 6 $(60)$ | 20 | GaAs melting |
| 8 | 1000 | 2 | 6 $(60)$ | 10 | Condensation |
| 9 | 1250 | 2 | 6 $(60)$ | 10 | GaAs melting |
| 10 | 1238 | 2 | 0.3 $(3)$ | 30 | Temperature stabilization |
| 11 | 1238 | 2 | 0.3 $(3)$ | 300 | Growth of the crystal |
| 12 | 1238–30 | 2 | 0.3 $(3)$ | 600 | Cooling |

(1)   Values measured inside the crucible

(2)   See Figure 1.

EP 0 206 541 B1

Table 2A: STAGES of the Honeywell DCP 7700 programmer for the synthesis and the growth of the GaAs in CZ oven of channel 3 (CH3)

| Programmer channel | Stage (No.) | Set point (mV) | Fixed value (time in minutes) | RAMP (time in minutes) | NOTES |
|---|---|---|---|---|---|
| 3 | 1 | 229 | 0 | | Oven start-up (Nitrogen 1MPa (10 atm)); crucible in gradient type 1, fig. 1 |
| | 2 | | | 20 | |
| | 3 | 287 | 20 | | $B_2O_3$ Melting |
| | 4 | | | 15 | nitrogen input (6 MPa (60 atm)) |
| | 5 | 305 | 15 | | Crucible in gradient type 2, fig. 1 |
| | 6 | | | 20 | |
| | 7 | 330 | 15 | | Reaction |
| | 8 | | | 20 | |
| | 9 | 420 | 10 | | GaAs melting |
| | 10 | 350 | 10 | | Condensation |
| | 11 | 420 | 10 | | GaAs melting |
| | 12 | 360 | 5 | | Nitrogen pressure 0.3 MPa (3 atm) |
| | 13 | 360 | 590 | | Crystal growth |
| | 14 | | | 240 | Cooling |
| | 15 | 300 | 0 | | |

EP 0 206 541 B1

TABLE 2B: STAGES of the Honeywell DCP 7700 programmer for the synthesis and the growth of the GaAs singlecrystal in CZ oven of channel 2 (CH2)

| Programmer Channel | Stage (No.) | Set Point (mV) | Fixed value (time in minutes) | RAMP (time in minutes) | NOTES |
|---|---|---|---|---|---|
| 2 | 1 | 500 | 155 | | Synthesis |
| | 2 | 500 | 5 | | Stabilization of the temperature in the melt |
| | 3 | 500 | 10 | | Formation of the neck |
| | 4 | | | 35 | |
| | 5 | 480 | 10 | | |
| | 6 | | | 10 | Formation of the shoulder |
| | 7 | 474 | 0 | | |
| | 8 | | | 10 | |
| | 9 | 467 | 0 | | |
| | 10 | | | 15 | |
| | 11 | 455 | 0 | | |
| | 12 | | | 55 | |
| | 13 | 405 | 0 | | Start of cylinder formation |
| | 14 | | | 40 | |
| | 15 | 365 | 0 | | |
| | 16 | | | 15 | |
| | 17 | 353 | 0 | | |
| | 18 | | | 20 | |
| | 19 | 341 | 0 | | |
| | 20 | | | 120 | |
| | 21 | 281 | 840 | | Cooling |
| | 22 | 229 | 0 | | |

EP 0 206 541 B1

EP 0 206 541 B1

TABLE 2C:     STAGES of the Honeywell DCP 7700 programmer for the synthesis and the growth of GaAs singlecrystal in CZ oven of channel 2 (CH2)

| Programme channel | Stage (No.) | Set point (mV) | Fixed value (time in minutes) | RAMP (time in minutes) | $\Delta$ Set Point/Ramp (mV/min) | NOTES |
|---|---|---|---|---|---|---|
| 2 | 1 | 500 | 76 | | | Melting |
| | 2 | 500 | 5 | | | Neck |
| | 3 | 500 | 10 | | | " |
| | 4 | | | 35 | 0.57 | " |
| | 5 | 480 | 10 | | | " |
| | 6 | | | 10 | 0.6 | Cone (shoulder) |
| | 7 | 474 | 0 | | | " |
| | 8 | | | 10 | 0.7 | " |
| | 9 | 467 | 0 | | | " |
| | 10 | | | 15 | 0.8 | " |
| | 11 | 455 | 0 | | | " |
| | 12 | | | 55 | 0.9 | " |
| | 13 | 405 | 0 | | | Cylinder |
| | 14 | | | 60 | 1.0 | " |
| | 15 | 345 | 0 | | | " |
| | 16 | | | ·25 | 0.8 | " |
| | 17 | 325 | 0 | | | " |
| | 18 | | | 40 | 0.6 | " |
| | 19 | 301 | 0 | | | " |
| | 20 | | | 120 | 0.5 | " |
| | 21 | 245 | 0 | | | " |
| | 22 | 241 | 840 | | | Cooling |
| | 23 | 229 | 0 | | | " |

$\Delta$ = Difference

TABLE 2D:

TABLE 2D: STAGES of the Honeywell DCP 7700 programmer for the synthesis and the growth of GaAs singlecrystal in CZ oven of channel 2 (CH2)

| Programmer channel | Stage (No.) | Set point | Fixed value (time in minutes) | RAMP (time in minutes) | Δ Set point/Ramp (mV/min.) | NOTES |
|---|---|---|---|---|---|---|
| 2 | 1 | 500 | 76 | | | Melting |
| | 2 | 500 | 5 | | | Neck |
| | 3 | 500 | 10 | | | " |
| | 4 | | | 35 | 0.57 | " |
| | 5 | 480 | 10 | | | " |
| | 6 | | | 10 | | Cone (shoulder) |
| | 7 | 477 | 0 | | | " |
| | 8 | | | 10 | 0.35 | " |
| | 9 | 473 | 0 | | | " |
| | 10 | | | 15 | 0.4 | " |
| | 11 | 467 | 0 | | | " |
| | 12 | | | 55 | 0.45 | " |
| | 13 | 442 | 0 | | | Cylinder |
| | 14 | | | 90 | 0.5 | " |
| | 15 | 397 | 0 | | | " |
| | 16 | | | 20 | 0.4 | " |
| | 17 | 389 | 0 | | | " |
| | 18 | | | 20 | 0.3 | " |
| | 19 | 383 | 0 | | | " |
| | 20 | | | 200 | 0.5 | " |
| | 21 | 333 | 840 | | | Cooling |
| | 22 | 229 | 0 | | | " |

Δ = Difference

TABLE 2E: STAGES of the Honeywell DCP 7700 programmer for the synthesis and the growth of GaAs singlecrystal in CZ oven of channel 2 (CH2)

| Programmer channel | Stage (No) | Set point (mV) | Fixed value (time in minutes) | RAMP (time in minutes) | Δ Set point/Ramp (mV/min) | NOTES |
|---|---|---|---|---|---|---|
| 2 | 1 | 500 | 76 | | | Melting |
| | 2 | 500 | 5 | | | " |
| | 3 | 500 | 10 | | | Neck |
| | 4 | 480 | 10 | 35 | 0.57 | " |
| | 5 | 474 | 0 | | | " |
| | 6 | 467 | 0 | 10 | 0.6 | Cone (shoulder) |
| | 7 | 455 | 0 | | | " |
| | 8 | 405 | 0 | 10 | 0.7 | " |
| | 9 | 397 | 0 | | | " |
| | 10 | 313 | 0 | 15 | 0.8 | " |
| | 11 | 229 | | 55 | 0.9 | " |
| | 12 | | | 10 | 0.8 | " |
| | 13 | | 840 | 120 | 0.7 | Cylinder |
| | 14 | | 0 | | | " |
| | 15 | | | | | " |
| | 16 | | | | | Cylinder |
| | 17 | | | | | Cooling |
| | 18 | | | | | " |

Δ = Difference

## Claims

1. A gallium arsenide single crystal, characterised by having a diameter from 2.5 to 5.1 cm (1 to 2 inches), a weight from 200 g to 1 kg, an impurity content of less than or equal to $5.10^{15}$ atoms/cm$^3$, a dislocation density, both axial and radial, of from $5.10^2$ to $8.10^3$ cm$^{-2}$, without the use of dopant, a diameter constancy of ± 2 mm, a circular section cylindrical shape, and any predetermined orientation.

2. A gallium arsenide single crystal as claimed in claim 1, characterised by being oriented according to the direction ⟨111⟩ or ⟨100⟩.

3. A gallium arsenide single crystal as claimed in claim 2, characterised by having the orientation ⟨111⟩ with a number of dislocations of from $5.10^2$ to $10^3$ cm$^{-2}$.

4. A gallium arsenide single crystal as claimed in claim 2, characterised by having the orientation ⟨100⟩

EP 0 206 541 B1

with a number of dislocations of from $10^3$ to $8.10^3$ cm$^{-2}$.

5. A gallium arsenide single crystal as claimed in any of claims 1 to 4, characterised by being doped with $10^{17}$ - $10^{18}$ atoms/cm$^3$ of dopant without any microprecipitates and with a number of dislocations of from 0 to $10^2$ cm$^{-2}$.

6. A gallium arsenide single crystal as claimed in claim 5, characterised in that the dopant is selected from silicon, sulphur, tellurium, selenium, boron, chromium and zinc.

7. A process for the preparation of a gallium arsenide single crystal according to claim 1, with the LEC technique in a single cycle, characterised by comprising the following steps:
a) preparing a gallium arsenide polycrystal in situ by the reaction of the elements gallium (Ga) and arsenic (As), under inert gas high pressure conditions of at least 5 MPa (50 atm), operating in the presence of a quantity of $B_2O_3$ sufficient to produce a molten layer from 0.7 to 2 cm thick, using a commercial voltage ramp programmer on a voltage output channel having minimum voltage increments of about 10 mV, said voltage being increased during this step in such a way as to limit the As evaporation to less than 1% by weight with respect to the initial quantity of As used, during the entire step so that the stoichiometry of the polycrystal is comprised between the following values:

$$0.49 < \frac{As}{Ga + As} < 0.51;$$

b) growing a single crystal using the polycrystal obtained in step (a) which comprises melting the polycrystal at a temperature from 1250$^\circ$C to 1300$^\circ$C, under an inert gas pressure of 6 to 7 MPa (60 - 70 atm) in a growth chamber; lowering the temperature until the contact between seed and molten material is formed; and a growth phase at a low inert gas pressure of from 0.2 to 0.6 MPa (2 to 6 atm), or at a high pressure of from 2.5 to 5 MPa (25 to 50 atm), for formation of a neck being 2-3 mm in diameter and 5-14 mm long, formation of a shoulder in 1-2 hours, and formation of the circular section cylindrical shape single crystal of constant diameter;
the said step (b) being carried out with temperature control automatically obtained by means of the use of a microprocessor inserted between the oven and the programmer, which permits output voltages to be obtained from said programmer with increments of not more than 1 mV; and
c) cooling the single crystal by a slow and controlled decreasing stage at 30$^\circ$-60$^\circ$C/hour until a temperature of 900$^\circ$-1000$^\circ$C is reached and a faster cooling stage at 80$^\circ$ - 120$^\circ$C/hour until room temperature is reached.

8. A process as claimed in claim 7, characterised in that the pulling speed of the seed in the growth phase of the single crystal varies from 0.5-2 cm/hour, the anticlockwise shaft rotation speed is 1.5-6 rpm, and the crucible rotation speed is 2-5 rpm.

9. A gallium arsenide polycrystal obtained according to step a) of claim 7, characterised by having stoichiometry included in the following range:

$$0.49 < \frac{As}{Ga + As} < 0.51;$$

and an impurity content of not more than $5.10^{15}$ atoms/cm$^3$.

**Revendications**

16

1. Un monocristal d'arséniure de gallium, caractérisé en ce qu'il a un diamètre compris entre 2,5 et 5,1 cm (1 à 2 pouces), un poids compris entre 0,2 et 1 kg, une teneur en impuretés au plus égale à 5 x $10^{15}$ atomes/cm$^n$, une densité de dislocation à la fois axiale et radiale comprise entre 5 x $10^2$ et 8 x $10^3$ cm$^{-2}$, sans utiliser de dopants, une constance du diamètre de ± 2 mm, une forme cylindrique à section circulaire et ayant n'importe quelle orientation prédéterminée.

2. Un monocristal d'arséniure de gallium, selon la revendication 1, caractérisé en ce qu'il est orienté selon les directions ⟨111⟩ ou ⟨100⟩.

3. Un monocristal d'arséniure de gallium, selon la revendication 2, caractérisé en ce qu'il est orienté selon la direction ⟨111⟩ tout en ayant un nombre de dislocations compris entre 5 x $10^2$ et $10^3$ cm$^{-2}$.

4. Un monocristal d'arséniure de gallium, selon la revendication 2, caractérisé en ce qu'il est orienté selon la direction ⟨100⟩ tout en présentant un nombre de dislocations compris entre $10^3$ et 8 x $10^3$ cm$^{-2}$.

5. Un monocristal d'arséniure de gallium, selon l'une quelconque des revendications 1 à 4, caractérisé en ce qu'il est dopé avec un dopant d'une concentration comprise entre $10^{17}$ et $10^{18}$ atomes/cm$^n$ sans présenter de microprécipités et avec un nombre de dislocations compris entre 0 et $10^2$ cm$^{-2}$.

6. Un monocristal d'arséniure de gallium, selon la revendication 5, caractérisé en ce que le dopant est choisi parmi les éléments suivants: silicium, soufre, tellure, sélénium, bore, chrome et zinc.

7. Un procédé pour la préparation d'un monocristal d'arséniure de gallium selon la revendication 1, en utilisant la technique LEC en un cycle unique, caractérisé en ce qu'il comporte les étapes suivantes:

a) préparation d'un polycristal d'arséniure de gallium in situ en faisant réagir les éléments gallium (Ga) et arsenic (As), sous un matelas de gaz inerte à une pression d'au moins 5 MPa (50 atm), la mise en oeuvre se faisant en présence d'une quantité suffisante de $B_2O_3$ pour produire une couche en fusion d'une épaisseur comprise entre 0,7 et 2 cm, la préparation se faisant de plus en utilisant un système couramment commercialisé permettant la programmation de la gradation de tension agissant sur un canal de sortie de tension, canal qui a des incréments minima de tension d'environ 10 mV, ladite tension étant accrue durant cette étape de façon que l'évaporation de l'arsenic soit limitée à des valeurs moindres que 1% en poids par rapport à la quantité initiale d'arsenic utilisé pendant toute l'étape de sorte que la stoechiométrie du polycristal est comprise entre les valeurs suivantes:

$$0,49 < \frac{As}{Ga + As} < 0,51$$

b) étape de croissance d'un monocristal utilisant le polycristal obtenu à l'étape (a), étape qui comprend la fusion du polycristal à une température comprise entre 1250 et 1300° C, sous un matelas de gaz inerte à une pression comprise entre 6 et 7 MPa (60 - 70 atm) dans une enceinte de croissance; abaissement de la température jusqu'à ce que le contact entre le germe et le matériau en fusion soit réalisé; la phase de croissance cristalline à lieu sous une pression de gaz inerte qui est, soit basse (0,2 à 0,6 MPa) (2 à 6 atm), soit élevée (2,5 à 5 MPa) (25 à 50 atm), pour réaliser la formation d'un col de 2 à 3 mm de diamètre et de 5 à 14 mm de long, et pour avoir aussi formation d'un épaulement en une durée de 1 à 2 heures, le monocristal de forme cylindrique et de section circulaire à diamètre constant se formant ensuite;

ladite étape (b) étant menée sous une température contrôlée automatiquement et qui est obtenue au moyen de l'utilisation d'un microprocesseur inséré entre le four et le système de programmation, lequel permet d'obtenir des tensions de sortie à partir dudit système de programmation avec des incréments de tension qui sont inférieurs ou égaux à 1 mV; et

c) étape de refroidissement du monocristal qui comprend une étape de décroissance lente et sous commande à un taux de décroissance situé entre 30° et 60° C/heure, jusqu'à ce qu'une température comprise entre 900 et 1000° C soit atteinte et une étape de refroidissement plus rapide à un taux de refroidissement compris entre 80 et 120° C/heure jusqu'à ce que l'on atteigne la température ambiante.

8. Un procédé selon la revendication 7, caractérisé en ce que la vitesse d'étirage du germe dans la phase de croissance du monocristal varie de 0,5 - 2 cm/heure, la vitesse de rotation de l'arbre dans le sens inverse des aiguilles d'une montre étant de 1,5 à 6 tr/mn et celle du creuset de 2 à 5 tr/mn.

9. Un polycristal d'arséniure de gallium obtenu selon l'étape a) de la revendication 7, caractérisé en ce qu'il a une stoechiométrie comprise dans la plage suivante:

$$0,49 < \frac{As}{Ga + As} < 0,51$$

et une teneur en impuretés qui est inférieure ou égale à $5,10^{15}$ atomes/$cm^n$.

**Patentansprüche**

1. Galliumarsenideinkristall, dadurch gekennzeichnet, daß es einen Durchmesser von 2,5 bis 5,1 cm (1 bis 2 inches), ein Gewicht von 200 g bis 1 kg, eine Verunreinigungsgehalt von weniger als oder gleich $5x10^{15}$ Atome/$cm^3$, eine sowohl axiale als auch radiale Versetzungsdichte von $5x10^2$ bis $8x10^3$ $cm^{-2}$ ohne Verwendung eines Dotiermittels, eine Konstanz des Durchmessers von ± 2 mm, eine im Kreisschnitt zylindrische Form und irgendeine vorherbestimmte Orientierung aufweist.

2. Galliumarsenideinkristall gemäß Anspruch 1, dadurch gekennzeichnet, daß es gemäß der Richtung ⟨111⟩ oder ⟨100⟩ orientiert ist.

3. Galliumarsenideinkristall gemäß Anspruch 2, dadurch gekennzeichnet, daß es die Orientierung ⟨111⟩ mit einer Anzahl von Versetzungen von $5x10^2$ bis $10^3$ $cm^{-2}$ aufweist.

4. Galliumarsenideinkristall gemäß Anspruch 2, dadurch gekennzeichnet, daß es die Orientierung ⟨100⟩ mit einer Anzahl von Versetzungen von $10^3$ bis $8x10^3$ $cm^{-2}$ aufweist.

5. Galliumarsenideinkristall gemäß irgendeinem der Ansprüche 1 bis 4, dadurch gekennzeichnet, daß es mit $10^{17}$ bis $10^{18}$ Atomen/$cm^3$ eines Dotiermittels ohne irgendwelche Mikroprezipitate und mit einer Anzahl von Versetzungen von 0 bis $10^2$ $cm^{-2}$ dotiert ist.

6. Galliumarsenideinkristall gemäß Anspruch 5, dadurch gekennzeichnet, daß das Dotermittel aus Silicium, Schwefel, Tellur, Selen, Bor, Chrom und Zink ausgewählt ist.

7. Verfahren zur Herstellung eines Galliumarsenideinkristalles gemäß Anspruch 1 nach der LEC-Technik im Einzelzyklus, dadurch gekennzeichnet, daß es die folgenden Schritte umfaßt:
   a) Herstellen eines Galliumarsenidmehrkristalles in situ durch Reaktion der Elemente Gallium (Ga) und Arsen (As) unter Hochdruckbedingungen eines inerten Gases von mindestens 5 nPa (50 atm), wobei man in Gegenwart einer ausreichenden Menge an $B_2O_3$ arbeitet, um eine geschmolzene Schicht von 0,7 bis 2 cm Dicke zu erhalten, unter Anwendung eines handelsüblichen programmierbaren Rampenfunktions-Spannungsgenerators mit Spannungsmindestinkrementen von etwa 10 mV auf einem Spannungsausgangskanal, wobei diese Spannung während dieses Schrittes so erhöht wird, daß die Verdampfung von As während des gesamten Schrittes weniger als 1 Gew.-%, bezogen auf die verwendete Anfangsmenge von As, beträgt, so daß die Stöchiometrie des Mehrkristalles zwischen den folgenden Werten liegt:

$$0,49 < \frac{As}{Ga + As} < 0,51$$

b) Züchten eines Einkristalles unter Verwendung des in Schritt (a) erhaltenen Mehrkristalles, das umfaßt: das Schmelzen des Mehrkristalles bei einer Temperatur von 1250 bis 1300˚C unter einem inerten Gasdruck von 6 bis 7 nPa (60 bis 70 atm) in einer Züchtungskammer; das Senken der Temperatur, bis sich ein Kontakt zwischen dem Keimkristall und dem geschmolzenen Material bildet; und eine Wachstumsphase bei einem geringen inerten Gasdruck von 0,2 bis 0,6 nPa (2 bis 6 atm) oder bei einem Hochdruck von 2,5 bis 5 nPa (25 bis 50 atm) zur Bildung eines Halses von 2 bis 3 mm Durchmesser und 5 bis 14 mm Länge, zur Bildung einer Schulter in 1 bis 2 h und zur Bildung eines Einkristalles von konstantem Durchmesser mit einem Kreisschnitt von zylindrischer Form;

wobei der Schritt (b) unter automatischer Temperaturregelung durch Verwendung eines Mikroprozessors durchgeführt wird, der zwischen dem Ofen und der Programmiervorrichtung eingefügt ist und die Erzielung von Ausgangsspannungen aus dieser Programmiervorrichtung mit Inkrementen von nicht mehr als 1 mV erlaubt; und

c) Abkühlen des Einkristalles durch langsames und geregeltes Absenken bei 30 bis 60˚C/h, bis eine Temperatur von 900 bis 1000˚C erreicht ist, und schnelleres Abkühlen bei 80 bis 120˚C/h, bis Raumtemperatur erreicht ist.

**8.** Verfahren gemäß Anspruch 7, dadurch gekennzeichnet, daß die Zuggeschwindigkeit des Keimkristalles in der Wachstumsphase des Einkristalles von 0,5 bis 2 cm/h variiert, die Rotationsgeschwindigkeit des Schaftes im entgegengesetzten Uhrzeigersinn 1,5 bis 6 U/min beträgt und die Rotationsgeschwindigkeit des Schmelztiegels 2 bis 5 U/min beträgt.

**9.** Galliumarsenidmehrkristall, erhalten gemäß Schritt a) von Anspruch 7, dadurch gekennzeichnet, daß es eine Stöchiometrie im folgenden Bereich

$$0,49 < \frac{As}{Ga + As} < 0,51$$

und einen Verunreinigungsgehalt nicht über $5 \times 10^{15}$ Atomen/cm$^3$ aufweist.

FIG.1.

FIG. 2.

Time(h)

a) Volts 4 0

b) mV 400 0

c) Volts 4 0

i) ii) iii)